# EUROPÄISCHE PATENTSCHRIFT

(11) **EP 3 970 176 B1**
(45) Veröffentlichungstag und Bekanntmachung des Hinweises auf die Patenterteilung: **30.08.2023**
(21) Anmeldenummer: 20732882.4
(22) Anmeldetag: 12.06.2020
(51) Int. Cl.: H01H 71/40

(54) **ELEKTRONISCHES INSTALLATIONSGERÄT**
ELECTRONIC INSTALLATION DEVICE
APPAREIL D'INSTALLATION ÉLECTRONIQUE

(30) Priorität: 21.06.2019 DE 102019116789
(43) Veröffentlichungstag der Anmeldung: 23.03.2022
(73) Patentinhaber: Schneider Electric Industries SAS, 92500 Rueil-Malmaison (FR)
(72) Erfinder: CANET, Thomas, 51709 Marienheide (DE); KNEIFEL, Christian, 57290 Neunkirchen (DE); ZHANG, May, Shenzhen 518000 (CN); HAO, Linda, Shenzhen 518000 (CN)
(74) Vertreter: Manitz Finsterwald Patent- und Rechtsanwaltspartnerschaft mbB
(86) Internationale Anmeldenummer: PCT/EP2020/066404
(87) Internationale Veröffentlichungsnummer: WO 2020/254213

(56) Entgegenhaltungen:
- EP-A1- 0 037 490
- EP-A1- 0 519 346
- DE-A1-102017 110 897
- DE-U1-202015 106 694

## Beschreibung

Die Erfindung betrifft ein elektronisches Installationsgerät nach dem Oberbegriff des Patentanspruches 1. Ein Installationsgerät gemäß dem Oberbegriff des Anspruchs 1 ist aus der DE 10 2017 110897 A1 bekannt.

Derartige elektronische Installationsgeräte können Schaltkontakte, z.B. eines Relais, oder Leistungshalbleiterbauelemente zur Laststromführung und elektronische Steuereinrichtungen zur Ansteuerung einer Relaisspule oder zur Ansteuerung von Leistungshalbleiterbauelementen enthalten.

Häufig werden solche elektronischen Installationsgeräte in elektrischen Installationssystemen der Gebäudetechnik eingesetzt und sind für einen Laststrom ausgelegt, der deutlich unter dem Nennstrom, z.B. 16 Ampere, der in der Gebäudeinstallation üblichen Stromkreise liegt. Beispielsweise sind Jalousieschalter, Zeitschaltuhren etc. für einen Laststrom in Bereichen zwischen 3 Ampere und 8 Ampere ausgelegt.

Die elektronischen Installationsgeräte müssen bei normgerechter Prüfung mit dem Auslösestrom eines vorgeschalteten Sicherungselementes, vorzugsweise einem Leitungsschutzschalter, der Gebäudeinstallation geprüft werden. Aufgrund der Differenz zwischen dem Laststrom eines elektronischen Installationsgerätes und dem Auslösestrom des vorgeschalteten gebäudeseitigen Sicherungselementes wäre das elektronische Installationsgerät unzureichend, nämlich zu hoch, abgesichert. Bei einem Überstrom im Bereich zwischen dem Geräte-Nennstrom und dem Auslösestrom des vorgeschalteten Sicherungselementes der Gebäudeinstallation wäre das elektronische Installationsgerät ungeschützt und könnte zerstört werden.

Unter sicherheitstechnischen Aspekten ist in solchen Fällen die Anordnung einer geräteeigenen Sicherung erforderlich, um vor Überstrom zu schützen. Es ist bekannt, in elektronischen Systemen mit einem Lastkreis und mit einem Steuerstromkreis schnell ansprechende Schmelzsicherungen, die vorzugsweise im Lastkreis angeordnet, als geräteeigene Sicherungen einzusetzen. Elektronische Systeme werden durch eine derartige Überstromschutzeinrichtung zuverlässig gegen einen Kurzschlussstrom im Lastkreis geschützt.

Wenn im Lastkreis ein Strom fließt, der kleiner als der Kurzschlussstrom, aber größer als der Geräte-Nennstrom ist, können elektrische Bauelemente weiterhin geschädigt werden. Allgemein ist diese sogenannte Überlast als ein Überschreiten des zulässigen Stromes im elektrisch unbeschädigten Stromkreis definiert. Dabei zerstört die strombedingte Wärmeentwicklung elektrische Leiter und Bauelemente durch Überschreiten zulässiger Grenztemperaturen. Eine Überlastschutzeinrichtung detektiert die Erwärmung von Leitern und/oder Bauelementen und schaltet den Stromkreis zumindest temporär ab.

Kurzschlussströme und Überlastströme bedingen unterschiedliche technische Anforderungen an Schutzeinrichtungen. Sowohl bei Kurzschluss als auch bei Überlast erwärmen sich stromführende Leitungen auf unzulässig hohe Temperaturen. Wesentlicher Unterschied ist, dass im Kurzschlussfall bei hohen Kurzschlussströmen die unzulässig hohe Wärmemenge schon in Bruchteilen einer elektrischen Halbschwingung erreicht werden kann. Schmelzsicherungen schmelzen auch bei hohen Kurzschlussströmen innerhalb einer ausreichend kurzen Zeit ab. Im Überlastfall treten Ströme auf, die nur wenig oberhalb der max. dauernd zulässigen Belastbarkeit einer Leitung liegen, und erwärmen die Leitung erst nach längerer Zeit auf unzulässig hohe Temperaturen. In einem so belasteten Stromkreis kann eine, vorzugsweise reversible, Sicherung gewährleisten, dass die unzulässig hohe Temperatur an den Leitern und Bauelementen nicht erreicht werden kann und ein Schutz bei Überlast existiert.

Mit einer einzigen geräteinternen Vorsicherung kann sowohl der Kurzschlussfall als auch der Überlastfall abgesichert werden. Dabei orientiert sich die Bemessung der Schmelzsicherung allerdings an dem niedrigeren Wert für den Überlastfall. Dies hat zur Folge, dass die Sicherung öfter als notwendig auslöst. Nachteilig ist, dass solche Schmelzsicherungen nach Auslösen zerstört sind und damit ausgetauscht werden müssen, um die Funktionsfähigkeit des Geräts nach Beseitigung der Überlastsituation wieder her zu stellen.

Bekannte Geräteschutzschalter oder Leitungsschutzschalter, die beide Überstromfälle spezifisch absichern, lassen sich bei elektronischen Geräten, die kleinteilig und hauptsächlich auf Leiterbahnen realisiert werden, aufgrund ihrer Größe und Struktur nicht einsetzen. Thermische Schutzeinrichtungen mit mechanischen Komponenten lassen sich als Überlastschutz aufgrund ihrer Größe ebenfalls nicht verwenden.

Des Weiteren sind selbstrückstellende Sicherungen, beispielsweise elektrische Bauelemente mit PTC-Charakteristik (positive temperature coefficient), bekannt, die aus einem Kaltleiter auf Polymerbasis mit nichtlinearem Widerstandsverlauf bestehen. Dieser Kaltleiter ist bei Normaltemperatur niederohmig. Erwärmt sich der Kaltleiter beispielsweise durch externe Wärmezufuhr, wird er hochohmig, wodurch der Stromfluss stark beschränkt wird. Wird die Wärmezufuhr reduziert, kühlt der Kaltleiter ab und wird wieder niederohmig.

Elektronische Installationsgeräte sind überwiegend kleinteilig auf Leiterbahnpaketen realisiert. Eine Umsetzung eines vollständigen Überstromschutzes auf Basis von Leiterbahnstrukturen ist bisher nicht bekannt, da insbesondere die übliche Leiterbahngeometrie mit geringen Schichtdicken und großen Oberflächen für die Belastung mit unterschiedlichen Stromgrenzwerten nicht geeignet ist. Die Kurzschluss-Absicherung mit einer Schmelzsicherung erfordert an allen übrigen Stellen der Leiterbahnstruktur ein höheres Schmelzintegral und folglich große Leiterbahnoberflächen. Die für eine Überlastabsicherung mittels PTC-Elemente notwendige Wärmeerzeugung und -abgabe eines Leiters lässt sich dagegen mit der üblichen Leiterbahnbreite nicht realisieren. Eine erforderliche verjüngte Leiterbahn würde aber im Kurzschlussfall zerstört werden.

Eine Realisierung einer Überlastsicherung auf PTC-Basis zur Folge, dass auf dem Leiterbahnpaket keine separate Kurzschluss-Sicherung möglich wäre. Die entsprechende Sicherung der Hausinstallation, meist ein reversibler Automat, müsste entsprechend dem geringeren Nennstrom des Installationsgerätes ausgetauscht werden.

Eine Lösung, die elektronische Installationsgeräte gegen beide Überstromszenarien spezifisch und optimal schützt, ist nicht bekannt.

Die Aufgabe der vorliegenden Erfindung besteht deshalb darin, die vorstehend genannten Nachteile zu beseitigen und ein elektronisches Installationsgerät mit geräteeigenen Schutzeinrichtungen gegen Kurzschluss und gegen Überlast zu realisieren.

Gelöst wird diese Aufgabe durch die im Patentanspruch 1 angegebenen Merkmale. Vorteilhafte Ausgestaltungen ergeben sich aus den Unteransprüchen.

Die Erfindung gemäß dem Patentanspruch 1 weist den Vorteil auf, dass das erfindungsgemäße elektronische Installationsgerät durch eine Kombination von zwei spezifischen aufeinander abgestimmten Schutzeinrichtungen gegen Überstrom geschützt ist. Eine erste Überstromschutzeinrichtung schützt vor einem Kurzschluss, während eine zweite Überstromschutzeinrichtung den Überlastfall absichert.

Das elektronische Installationsgerät kann mit einer Last in Reihe geschaltet werden. Schaltungstechnisch umfasst das elektronische Installationsgerät einen Laststromkreis und einen Steuerstromkreis, die thermisch und physikalisch/elektrisch gekoppelt sind. Der Laststromkreis umfasst eine erste Überstromschutzeinrichtung, ein Widerstandselement und ein Schaltungsunterbrechungselement, die in Reihe zwischen einer Stromquelle und einer elektrischen Last anordenbar sind.

Eine Überstromdetektierungseinrichtung wirkt mit einer Steuereinrichtung als zweite Überstromschutzeinrichtung zusammen. Die Steuereinrichtung ist in dem Steuerstromkreis angeordnet und funktional mit dem Schaltungsunterbrechungselement im Laststromkreis verbunden.

Die Überstromdetektierungseinrichtung kann ein Sensorelement im Steuerstromkreis, vorzugsweise ein reversibles elektrisches Bauelement, beispielsweise in Form eines Kaltleiters mit positivem Temperaturkoeffizienten (PTC), und ein Widerstandselement im Laststromkreis umfassen, das thermisch mit dem PTC-Element gekoppelt ist. Das Widerstandselement verläuft als Leiterbahn galvanisch getrennt unterhalb des PTC-Elementes.

Das elektronische Installationsgerät kann zumindest teilweise auf einer Leiterplattenanordnung realisiert sein und kann in dem Laststromkreis die erste Überstromschutzeinrichtung in Form einer Schmelzsicherung aufweisen, die die geräteeigenen elektrischen Bauelemente und Leiter bei einem Kurzschluss schützt. Dies bedeutet, dass das Schmelzintegral der geschützten Bauelemente und Leiterbahnen höher ist als das Schmelzintegral der Sicherung. Die Sicherung ist nur für den Kurzschlussfall und nicht für Überlastfall ausgelegt.

Das Widerstandselement in Form einer Leiterbahn des Laststromkreises ist spezifisch ausgelegt, um einerseits im Kurzschlussfall nicht zerstört zu werden und andererseits die Detektion der thermischen Energie im Überlastfall zu ermöglichen. Die Leiterbahn kann an dieser Stelle aus zwei parallel geschalteten Leiterbahnen unterschiedlicher Breite bestehen. Das Breitenverhältnis beträgt dabei vorzugsweise 5 zu 1. Die breite Leiterbahn nimmt den Kurzschlussstrom auf, während die schmale Leiterbahn zur Detektierung des Überlastfalles dient. Das gemeinsame Schmelzintegral beider Leiterbahnen ist dabei höher als das Schmelzintegral der Schmelzsicherung.

Unter normalen Betriebsbedingungen befindet sich das elektronische Installationsgerät in einem Zustand mit niedriger Temperatur und niedrigem Widerstand. Im Kurzschlussfall steigt der Strom sehr schnell an und bringt den Schmelzleiter in der ersten Überstromschutzeinrichtung zum Schmelzen, wodurch der Stromfluss durch die Sicherung dauerhaft unterbrochen ist. Da das gemeinsame Schmelzintegral der beiden Leiterbahnen des Widerstandselementes höher ist, erfolgt an dieser Stelle keine Beschädigung. Die schmale Leiterbahnspur wird dabei nicht zerstört, da bei hohem Stromfluss im Kurzschlussfall der Strom den Weg des geringsten Widerstandes über die ausreichend dimensionierte breite Leiterbahn nutzt. Die Schmelzsicherung löst bei Überlast im Bereich zwischen Kurzschlussstrom (Auslösestrom der Schmelzsicherung) und Nennstrom des Installationsgerätes nicht aus.

Im Überlastfall steigt der Strom durch das Widerstandselement vergleichsweise langsam an, wobei insbesondere die Umgebungstemperatur der schmalen Leiterbahn übermäßig ansteigt, und länger als die normale Betriebszeit beibehalten wird. Das Sensorelement wird durch die Umgebungstemperatur der Leiterbahn "ausgelöst", d. h. in einen Zustand mit hoher Temperatur und hohem Widerstand umgewandelt, so dass der Strom wesentlich reduziert wird. Der Wechsel der Widerstands- und Stromwerte wird an die Steuereinrichtung "kommuniziert" und bewirkt darin, dass das Schaltungsunterbrechungselement, z. B. ein Relais oder Leistungshalbleiterbauelement, im Laststromkreis von einem normalen Betriebszustand zu einem Auslösezustand wechselt und damit auch die Abschaltung der Last erfolgt.

Im Steuerstromkreis kann das Sensorelement mit einem Widerstand einen Spannungsteiler bilden, dessen sich ändernde Spannung in einen Mikrocontroller eingelesen und verarbeitet wird. Bei erkannter Überlast wird das an den Mikrocontroller angeschlossene Relais oder Leistungshalbleiterbauelement und damit auch die Last im Laststromkreis abgeschaltet. Alternativ ist es auch möglich, bei Überlast ohne Mikrocontroller abzuschalten. Steigt der Überlaststrom im Laststromkreis weiter an, heizt sich die schmale Leiterbahn des Widerstandselementes weiter auf, bis der abnehmende Steuerstrom des Sensorelementes den Haltestrom des Relais unterschreitet. Das Relais fällt ab und öffnet den Laststromkreis. Das Sensorelement bleibt im ausgelösten Zustand bis die Temperatur wieder normal ist und abkühlen konnte. Danach erfolgt die Rückkehr in den Normalzustand, d.h. die erneute Zuschaltung der Last. Das Sensorelement ist nicht in Reihe mit der Last angeordnet und kann daher bei Strompegeln arbeiten, die viel niedriger sind als der normale Stromkreis, der durch die Last fließt.

Die Bestimmung der Breite der beiden Leiterbahnen des Widerstandselementes erfolgt nach den folgenden Regeln. Für die Kurzschlussbetrachtung ist die Energie relevant, die in Form des Schmelzintegrals aufgenommen wird. Das Schmelzintegral der Leiterbahnen des Installationsgerätes muss höher sein als das Schmelzintegral der Sicherung. Das gemeinsame Schmelzintegral der beiden Leiterbahnen des Widerstandselementes muss auch gemäß dieser Vorgabe ausgelegt sein. Das Verhältnis der Schmelzintegrale der Leiterbahnen zueinander liegt vorzugsweise in einem Verhältnis größer als 25.

Durch diese Vorgaben lässt sich durch eine Umrechnung des auf einen Rundleiter bezogenen Schmelzintegrals der Schmelzsicherung der Durchmesser des Rundleiters bestimmen. Der sich ergebende Querschnitt kann auf die Mindestbreite der beiden Leiterbahnen umgerechnet werden. Bei Annahme eines Verhältnisses von 25 zu 1 für die Schmelzintegrale der beiden Leiterbahnen ergibt sich ein Verhältnis der Breite der Leiterbahnen von 5 zu 1. Dabei wird davon ausgegangen, dass die beiden Leiterbahnen aus demselben Material bestehen und dieselbe Dicke haben.

Das erfindungsgemäße elektronische Installationsgerät kann zumindest teilweise eine schichtweise oder paketweise Anordnung von Leiterplatten aufweisen, die aus einer oder mehreren Substratschichten besteht, auf denen jeweils ein- oder beidseitig elektrische Bauteile und/oder Leiterbahnen angeordnet sein können. Vorteilhafterweise sind die beiden Überstromschutzeinrichtungen an den beiden äußeren Hauptoberflächen der Leiterplattenanordnung ausgebildet. Auf einer unteren Substratschicht kann die erste Überstromschutzeinrichtung, in Form einer Schmelzsicherung, und auf einer oberen Substratschicht kann zumindest das Sensorelement der zweiten Überstromschutzeinrichtung, in Form eines PTC-Elementes, angeordnet sein. Unterhalb des Sensorelementes sind die parallelgeschalteten Leiterbahnen des Widerstandselementes angeordnet. Das entsprechend strukturierte Widerstandselement kann vorteilhafterweise aus einer breiten Leiterbahn und aus einer verjüngten Leiterbahn bestehen und kann in unterschiedlichen Substratschichten der Leiterplattenstruktur angeordnet sein. Insbesondere kann die schmale Leiterbahn oberflächennah oder auf der Oberfläche der äußeren Schicht angeordnet sein, um die Verwendung eines Sensorelementes auf der Oberfläche (SMD-Technik) der Leiterplattenanordnung zu ermöglichen. Die verjüngte Leiterbahn kann eine reduzierte Breite oder eine verdünnte Höhenabmessung haben. Neben den schaltungsrelevanten Funktionen dienen die verschiedenen Schichten der Leiterplattenstruktur zur Maximierung der Fläche der Leiterbahnen, um einem Kurzschlussstrom stand halten zu können. Als Standarddielektrikum wird FR4 mit gemeinsamer Höhe verwendet. Geeignete Sensorelemente bestehen aus einem PTC-leitfähigen Polymer, d.h. eine Zusammensetzung, umfassend ein organisches Polymer und einen teilchenförmigen leitfähigen Füllstoff und / oder einen leitfähigen anorganischen Füllstoff.

Erfindungsgemäße elektronische Installationsgeräte werden häufig zum Schutz von Schaltungsanordnungen mit gerätespezifisch relativ hohen Strom- und relativ niedrigen Spannungslasten eingesetzt, wie Jalousieschalter, Zeitschalter oder Gebläse. Derartige Schaltungen enthalten typischerweise elektrische Lasten, die beim Anlassen der Last, z.B. eines Motors, oder bei erschwerten Betriebsbedingungen, Überströme hervorrufen. Ein Vorteil des elektronischen Installationsschalters mit den integrierten Überstromschutzeinrichtungen besteht darin, dass er in bereits vorhandenen, an sich zu hoch abgesicherten Stromkreisen gefahrlos verwendet werden kann. Mit der erfindungsgemäßen Anordnung kann eine spezifische (höhere) geräteinterne Kurzschlusssicherung eingesetzt werden, die weder einen Austausch des üblichen Sicherungsautomaten der Hausinstallation noch einen am Überlaststrom orientierten (niedrigeren) Wert (z.B. 10 Ampere anstelle von 8 Ampere) zur Minimierung der Temperatureinwirkung aufweist. Eine unzulässig starke Erwärmung des elektronischen Installationsgerätes kann verhindern werden, da die Sicherung nur für Kurzschlüsse und nicht für Überlast eingesetzt wird. Folglich kann hausinstallationsseitig eine übliche Sicherungsgröße (16 Ampere) verwendet werden. Der Kurzschlussfall ist im Installationsgerät separat durch die erste Überstromschutzeinrichtung in Form einer Schmelzsicherung geschützt. Der Überlastfall wird durch die zweite Überstromschutzeinrichtung und nicht durch eine Schmelzsicherung geschützt. Es entsteht ein robuster Stromkreis, der auch mit erhöhten Spezifikationen für eine Motorlast einsetzbar ist (z.B. unter anormalen Bedingungen kann das Gerät 8 A ohne besondere Anomalitäten verarbeiten).

Die Grundstruktur von Leiterplattenanordnung unverändert aufrechterhalten bleiben. Material und Materialstärken von Substraten, Isolierschichten und Leiterbahnen bleiben gleich. Der Leiterbahnquerschnitt kann weiter mit optimierten Breiten-Dicken-Verhältnis realisiert werden, so dass auf kleinem Raum kompakt und kostengünstig bei kleinen Produktabmessungen produziert werden kann. Die Verwendung von und Bestückung mit elektronischen Bauelementen kann ebenfalls beibehalten werden. Die Prinzipien der vorliegenden Erfindung können in größeren Leiterplattenanordnungen und Unterbaugruppen, die gedruckte Leiterbahnen und Komponenten aufweisen, eingesetzt werden.

Weitere Einzelheiten, Merkmale und Vorteile der Erfindung ergeben sich aus nachfolgender Beschreibung eines bevorzugten Ausführungsbeispieles anhand der Zeichnungen.

Es zeigen:
- Figur 1: eine Schaltungsanordnung eines elektronischen Installationsgerätes,
- Figur 2: eine schematische Leiterplattenanordnung in einer Draufsicht,
- Figur 3: eine skizzierte Leiterplattenanordnung im Querschnitt und
- Figur 4a-d: verschiedene Schichten der Leiterplattenanordnung gemäß Figur 2 und Figur 3.

Gleiche oder gleichwirkende Bauteile sind in der nachfolgenden Beschreibung mit gleichen Bezugszeichen versehen.

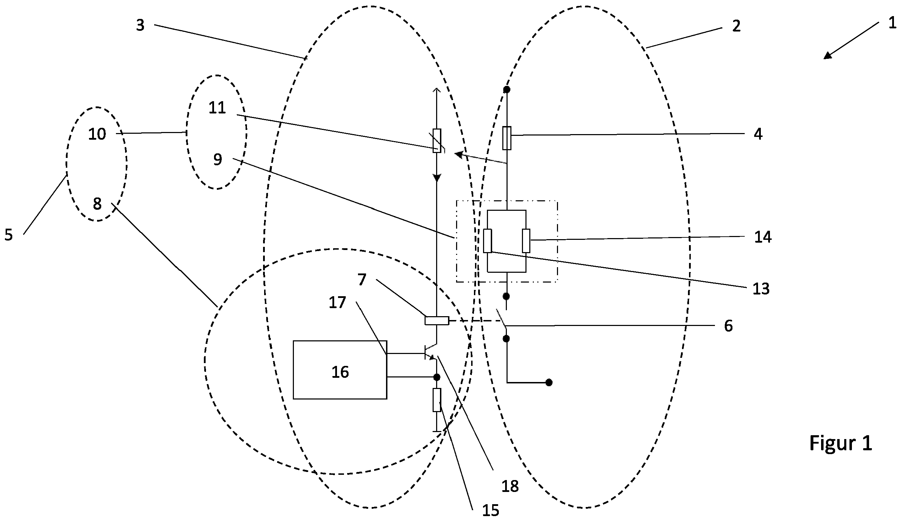

Fig. 1 zeigt eine prinzipielle Schaltungsanordnung zu einem elektronischen Installationsgerät 1. Das elektronische Installationsgerät 1 kann vorzugsweise mit einer Last (nicht dargestellt) in Reihe geschaltet werden. Schaltungstechnisch umfasst das elektronische Installationsgerät 1 einen Laststromkreis 2 und einen Steuerstromkreis 3, die thermisch, physikalisch und/oder elektrisch gekoppelt sind. Das elektronische Installationsgerät 1 ist durch eine Kombination von zwei spezifischen aufeinander abgestimmten Schutzeinrichtungen gegen Überstrom geschützt. Eine erste Überstromschutzeinrichtung 4 schützt vor einem Kurzschluss, während eine zweite Überstromschutzeinrichtung 5 den Überlastfall absichert.

Der elektronische Installationsgerät 1 enthält ein Schaltungsunterbrechungselement 6 in Form ein Schaltkontaktes eines Relais' 7 mit dem die elektrische Verbindung der Last zu einer Spannungsversorgung zu- und abschaltbar ist. Die Ansteuerung des Relais' 7 erfolgt durch eine Steuereinrichtung 8 im Steuerstromkreis 3, die Schaltbefehle an eine Spule des Relais' 7 zuführt.

Der Laststromkreis 2 weist eine erste Überstromschutzeinrichtung 4, ein Widerstandselement 9 und das Schaltungsunterbrechungselement 6 auf, die in Reihe zwischen einer Stromquelle (nicht dargestellt) und einer elektrischen Last angeordnet sind. Eine Überstromdetektierungseinrichtung 10 wirkt zusammen mit der Steuereinrichtung 8 als zweite Überstromschutzeinrichtung 5. Die Steuereinrichtung 8 ist in dem Steuerstromkreis 3 angeordnet und funktional mit dem Schaltungsunterbrechungselement 6 im Laststromkreis 2 verbunden. Die Überstromdetektierungseinrichtung 10 umfasst ein Sensorelement 11 im Steuerstromkreis 3, vorzugsweise ein reversibles elektrisches Bauelement in Form eines Kaltleiters mit positivem Temperaturkoeffizienten (PTC), und das Widerstandselement 9 im Laststromkreis 2, das thermisch mit dem PTC-Element 11 gekoppelt ist. Das Widerstandselement 9 verläuft als Leiterbahn galvanisch getrennt unterhalb des PTC-Elementes 11.

Das elektronische Installationsgerät 1 ist zumindest teilweise auf einer Leiterplattenstruktur 12 realisiert und weist in dem Laststromkreis 2 die erste Überstromschutzeinrichtung 4 in Form einer Schmelzsicherung auf, die die geräteeigenen elektrischen Bauelemente und Leiter bei einem Kurzschluss schützt. Dies bedeutet, dass das Schmelzintegral der geschützten Bauelemente und Leiterbahnen höher ist als das Schmelzintegral der Sicherung 4. Die Sicherung 4 ist nur für Kurzschluss und nicht für Überlast ausgelegt. Die eingesetzte zertifizierte Sicherung 4 ist ausgelegt, um Temperatureinflüsse zu minimieren und einen Auslösestrom zu verarbeiten. Im Kurzschlussfall wird der Laststromkreis 2 durch die Sicherung 4 dauerhaft unterbrochen.

Das Widerstandselement 9 in Form einer Leiterbahn des Laststromkreises ist spezifisch ausgelegt, um einerseits im Kurzschlussfall nicht zerstört zu werden und andererseits die Detektion der thermischen Energie im Überlastfall zu ermöglichen. Die Leiterbahn besteht an dieser Stelle aus zwei parallel geschalteten Leiterbahnen 13 und 14 unterschiedlicher Breite. Das Breitenverhältnis beträgt dabei vorzugsweise 5 zu 1. Die breite Leiterbahn 14 nimmt den Kurzschlussstrom auf, während die schmale Leiterbahn 13 zur Detektierung des Überlaststromes dient. Das gemeinsame Schmelzintegral beider Leiterbahnen 13 und 14 ist dabei höher als das Schmelzintegral der Schmelzsicherung 4.

Bezugnehmend auf Figur 1 wird nachfolgend die Funktionsweise des erfindungsgemäßen elektronischen Installationsgerätes 1 beschrieben. Dabei kann das elektrische Netz einer Hausinstallation den Betriebsstrom für das elektronische Installationsgerät 1 liefern. Wenn im Laststeuerkreis 2 das Schaltungsunterbrechungselement 6 des Relais' 7 geschlossen ist, fließt der Betriebsstrom zu der Last, beispielsweise einen Bürstenmotor mit relativ hohem Strom für eine Jalousiesteuerung. Eine Steuerstromquelle, die von der Primärstromquelle getrennt ist, liefert Steuerstrom für den Steuerstromkreis 3. Über das Sensorelement 11 fließt der Steuerstrom an eine Spule des Relais' 7 und bewirkt normalerweise ein Schließen des Schaltungsunterbrechungslementes 6, wodurch der Laststromkreis 2 geschlossen wird. Unter normalen Betriebsbedingungen befindet sich das elektronische Installationsgerät 1 in einem Zustand mit niedriger Temperatur und niedrigem Widerstand.

Ein Fehlerstrom ist ein Strompegel, der eine der Komponenten eines elektrischen Stromkreises beschädigt. Im Kurzschlussfall steigt der Strom sehr schnell an und bringt den Schmelzleiter in der ersten Überstromschutzeinrichtung 4 zum Schmelzen, wodurch der Stromfluss dauerhaft unterbrochen ist. Da das gemeinsame Schmelzintegral der beiden Leiterbahnen 13 und 14 des Widerstandselementes 9 höher ist, erfolgt an dieser Stelle keine Beschädigung. Die schmale Leiterbahn 13 wird dabei nicht zerstört, da bei hohem Stromfluss im Kurzschlussfall der Strom den Weg des geringsten Widerstandes über die ausreichend dimensionierte breite Leiterbahn 14 nutzt. Die Schmelzsicherung 4 löst bei Überlast im Bereich zwischen Kurzschlussstrom (Auslösestrom der Schmelzsicherung) und Nennstrom des elektronischen Installationsgerätes 1 nicht aus.

Im Überlastfall, wenn der Gerätenennstrom überschritten wird, beispielsweise der Motor blockiert, steigt der Strom durch das Widerstandselement 9 schnell aber vergleichsweise gering an, wobei insbesondere die Umgebungstemperatur der schmalen Leiterbahn 13 übermäßig ansteigt, und länger als die normale Betriebszeit beibehalten wird. Das PTC-Element 11 wird durch die Umgebungstemperatur der schmalen Leiterbahn 13 "ausgelöst", d. h. in einen Zustand mit hoher Temperatur und hohem Widerstand umgewandelt, so dass der Strom wesentlich reduziert wird. Der Wechsel der Widerstands- und Stromwerte wird an die Steuereinrichtung 8 "kommuniziert". Im Steuerstromkreis 3 bildet das PTC-Element 11 mit einem Widerstand 15 einen Spannungsteiler, dessen sich ändernde Spannung in einen Mikrocontroller 16 eingelesen und verarbeitet wird. Bei erkannter Überlast wird bewirkt, dass das an einen Ausgang 17 des Mikrocontrollers 16 über einen Transistor 18 angeschlossene Relais 7 abgeschaltet wird und das entsprechende funktional gekoppelte Schaltungsunterbrechungselement 6 öffnet und damit auch die Abschaltung der Last erfolgt. An dem Mikrocontroller 16 können unterschiedliche Betriebsarten einstellt werden. So kann beispielsweise festgelegt werden, ob die Last nach einiger Zeit selbsttätig wieder zugeschaltet werden soll, oder erst nach erneutem Einschaltbefehl oder nach einer Rückstellung der Unterbrechung des Laststromkreises 2. Auch die Auslösecharakteristik ist wählbar.

Alternativ ist es auch möglich, bei Überlast ohne Mikrocontroller 16 abzuschalten. Steigt der Überlaststrom im Laststromkreis 2 weiter an, heizt sich die Leiterbahn 13 und das Sensorelement 11 weiter auf, bis der abnehmende Strom im Steuerstromkreis 3 den Haltestrom des Relais' 7 unterschreitet. Die Relaisspule fällt ab und öffnet über das Schaltungsunterbrechungselement 6 den Laststromkreis 2. Das PTC-Element 11 bleibt im ausgelösten Zustand bis die Temperatur wieder normal ist und abkühlen kann. Danach erfolgt die Rückkehr in den Normalzustand, d.h. die erneute Zuschaltung der Last. Das PTC-Element 11 ist nicht in Reihe mit der Last angeordnet und kann daher bei Strompegeln arbeiten, die viel niedriger sind als der normale Stromkreis, der durch die Last fließt.

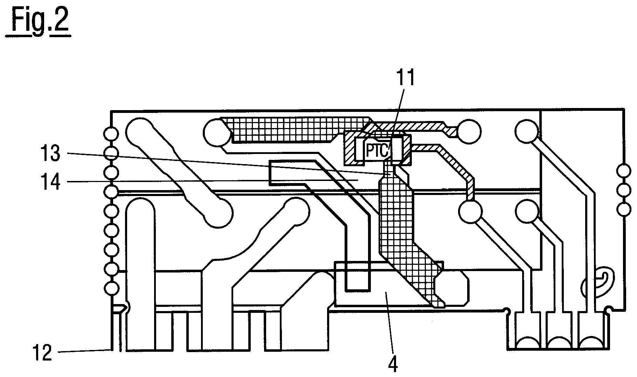

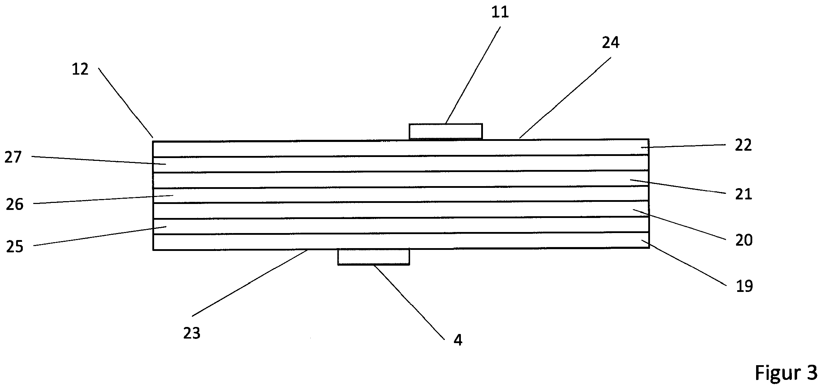

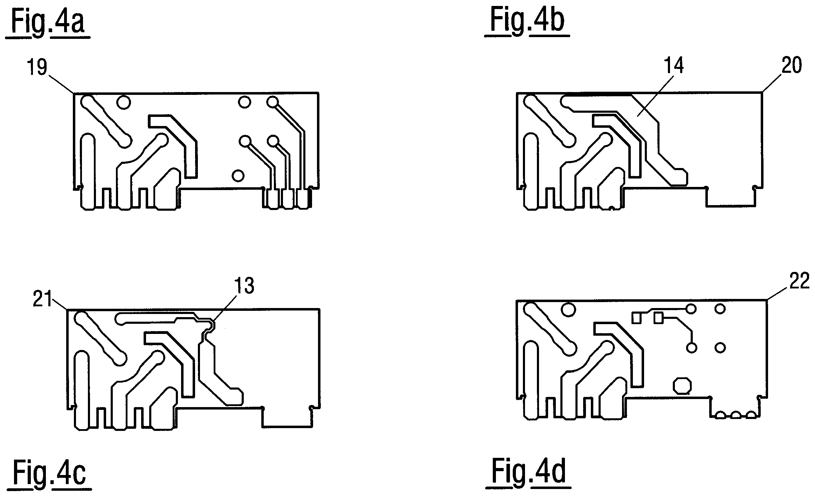

Bezugnehmend auf Figur 2 bis 4 ist eine mögliche Leiterplattenstruktur 12 des elektronischen Installationsgerätes 1 dargestellt, die aus einer oder mehreren Substratschichten 19 bis 22 besteht, die eine dielektrische Kernschicht mit jeweils ein- oder beidseitig angeordneten elektrischen Bauteilen und/oder Leiterbahnen aufweisen. An den beiden äußeren Hauptoberflächen 23 und 24 der Leiterplattenstruktur 12 sind die beiden Überstromschutzeinrichtungen 4 und 5 zumindest teilweise ausgebildet. Auf der unteren Substratschicht 19 ist die erste Überstromschutzeinrichtung, in Form einer Schmelzsicherung 4, und auf der oberen Substratschicht 22 ist zumindest das Sensorelement 11 der zweiten Überstromschutzeinrichtung 5, in Form eines PTC-Elementes, angeordnet. Unterhalb des PTC-Elementes sind die elektrisch parallelgeschalteten Leiterbahnen 13 und 14 des Widerstandselementes 9 angeordnet. Die entsprechend strukturierte Leiterbahn ist in unterschiedlichen Substratschichten der Leiterplattenstruktur 12 angeordnet. Die verjüngte Leiterbahn 13 ist in der Substratschicht 20 angeordnet, während die breite Leiterbahn 14 in der Substratschicht 21 angeordnet ist. Durch leitfähige Durchkontaktierungen sind die beiden Leiterbahnen 13 und 14 direkt verbunden. Insbesondere ist die schmale Leiterbahn 13 ist oberflächennah in der Schicht 20 angeordnet, um die Verwendung eines PTC-Elementes 11 auf der Oberfläche (SMD-Technik) zu ermöglichen. Das PTC-Element 11 auf der Substratschicht 19 steht in thermischem Kontakt mit der Substratschicht 20 direkt über der Oberfläche der verjüngten Leiterbahn 13, so dass dort infolge eines Überstromzustands Wärme erzeugt wird und effektiv zu dem PTC-Element 11 übertragen wird, so dass wie zuvor erläutert ein Steuersignal erzeugt wird.

Idealerweise sind die Schichten der Leiterplattenanordnung 12 so dünn wie es strukturell praktisch ist. Das dielektrische Material, das das Substrat bildet, kann ein dünnes Polyestermaterial oder ein anderes geeignetes dünnes flexibles Substrat sein. Ein dünnes, jedoch relativ starres Substrat aus Glasfaser verstärktem Harz kann ebenfalls verwendet werden. Die Strukturierung der Kupferschichten kann durch herkömmliche Photoresist- und chemische Ätztechniken durchgeführt werden, die dem Fachmann bekannt sind. Neben den schaltungsrelevanten Funktionen dienen die verschiedenen Schichten der Leiterplattenanordnung zur Maximierung der Fläche der Leiterbahnen, um einem Kurzschlussstrom stand halten zu können. Für die Isolierung zwischen den Substratschichten der Leiterplattenanordnung werden als Standarddielektrikum Schichten 25 bis 27 aus FR4 gemeinsamer Höhe verwendet. Geeignete PTC-Elemente 11 bestehen aus einem PTC-leitfähigen Polymer, d.h. eine Zusammensetzung, umfassend ein organisches Polymer und einen teilchenförmigen leitfähigen Füllstoff und / oder einen leitfähigen anorganischen Füllstoff.

### Bezugszeichenliste

- 1: elektronisches Installationsgerät
- 2: Laststromkreis
- 3: Steuerstromkreis
- 4: erste Überstromschutzeinrichtung
- 5: zweite Überstromschutzeinrichtung
- 6: Schaltungsunterbrechungselement
- 7: Relais
- 8: Steuereinrichtung
- 9: Widerstandselement
- 10: Überstromdetektierungseinrichtung
- 11: Sensorelement
- 12: Leiterplattenanordnung
- 13: schmale Leiterbahn
- 14: breite Leiterbahn
- 15: Widerstand
- 16: Mikrocontroller
- 17: Ausgang
- 18: Transistor
- 19: Substratschicht
- 20: Substratschicht
- 21: Substratschicht
- 22: Substratschicht
- 23: Oberfläche der Substratschicht 19
- 24: Oberfläche der Substratschicht 22
- 25: Isolierschicht
- 26: Isolierschicht
- 27: Isolierschicht

## Patentansprüche

1. Elektronisches Installationsgerät (1) zur Steuerung einer Last in einem elektrischen Stromkreis, das eine ein- oder mehrschichtige Leiterplattenanordnung (12) mit elektrischen Bauelementen und Leiterbahnen aufweist, das einen Laststromkreis (2) und einen Steuerstromkreis (3) umfasst, die zumindest funktional miteinander gekoppelt sind, wobei das elektronische Installationsgerät (1) eine Überstromschutzeinrichtung (5) zum Schutz vor Überlastströmen aufweist,
**dadurch gekennzeichnet, dass** der Laststromkreis (2) eine Überstromschutzeinrichtung (4) zum Schutz vor Kurzschlussströmen, ein Widerstandselement (9) und ein Schaltungsunterbrechungselement (6) aufweist, die in Reihe zwischen einer Stromquelle und einer elektrischen Last anordenbar sind.

2. Elektronisches Installationsgerät nach Anspruch 1, **dadurch gekennzeichnet, dass** der Steuerstromkreis (3) die Überstromschutzeinrichtung (5) zum Schutz vor Überlastströmen aufweist, die eine Überstromdetektierungseinrichtung (10) und eine Steuereinrichtung (8) aufweist, die funktional mit dem Schaltungsunterbrechungselement (6) verbunden ist.

3. Elektronisches Installationsgerät nach Anspruch 1 oder 2, **dadurch gekennzeichnet, dass** das Schaltungsunterbrechungselement (6) funktional mit einem Relais (7) oder mit Leistungshalbleiterbauelementen verbunden ist.

4. Elektronisches Installationsgerät nach einem der vorstehenden Ansprüche, **dadurch gekennzeichnet, dass** die Überstromschutzeinrichtung (4) zum Schutz vor Kurzschlussströmen irreversibel ist.

5. Elektronisches Installationsgerät nach Anspruch 2, **dadurch gekennzeichnet, dass** die Überstromdetektierungseinrichtung (10) aus einem reversiblen Sensorelement (11) im Steuerstromkreis (3) und aus dem Widerstandselement (9) im Laststromkreis (2) besteht, wobei das Sensorelement (11) thermisch mit dem Widerstandselement (9) gekoppelt ist.

6. Elektronisches Installationsgerät nach Anspruch 5, **dadurch gekennzeichnet, dass** das Sensorelement (11) ein Kaltleiter mit positivem Temperaturkoeffizienten ist.

7. Elektronisches Installationsgerät nach Anspruch 5 oder 6, **dadurch gekennzeichnet, dass** das Widerstandselement (9) als Leiterbahn galvanisch getrennt unterhalb des Sensorelementes (11) angeordnet ist.

8. Elektronisches Installationsgerät nach einem der vorstehenden Ansprüche, **dadurch gekennzeichnet, dass** das Widerstandselement (9) aus zwei parallel geschalteten Leiterbahnen (13, 14) unterschiedlicher Breite und/oder Dicke besteht.

9. Elektronisches Installationsgerät nach Anspruch 8, **dadurch gekennzeichnet, dass** das Breitenverhältnis zwischen den beiden Leiterbahnen (13, 14) bei gleicher Dicke und bei gleichem Material 5 zu 1 beträgt.

10. Elektronisches Installationsgerät nach Anspruch 8 oder 9, **dadurch gekennzeichnet, dass** eine schmale Leiterbahn (13) einen in der Breite verengten Abschnitt oder einen in der Höhe verdünnten Abschnitt umfasst.

11. Elektronisches Installationsgerät nach einem der Ansprüche 8 bis 10, **dadurch gekennzeichnet, dass** eine breite Leiterbahn (14) einen Kurzschlussstrom aufnimmt, während eine schmale Leiterbahn (13) zur Detektierung des Überlaststromes dient.

12. Elektronisches Installationsgerät nach einem der Ansprüche 8 bis 11, **dadurch gekennzeichnet, dass** die beiden Leiterbahnen (13, 14) des Widerstandselementes (9) in unterschiedlichen Schichten (19, 20, 21, 22) der Leiterplattenanordnung (12) angeordnet sind.

13. Elektronisches Installationsgerät nach Anspruch 5 und einem der Ansprüche 8 bis 12, **dadurch gekennzeichnet, dass** eine schmale Leiterbahn (13) oberflächennah oder auf der Oberfläche (24) einer äußeren Schicht (22) angeordnet ist, wobei das Sensorelement (11) thermisch kontaktiert und elektrisch isoliert zu der Leiterbahn (13) angeordnet ist.

14. Elektronisches Installationsgerät nach einem der Ansprüche 1 bis 13, **dadurch gekennzeichnet, dass** das Schmelzintegral von geschützten Bauelementen und Leiterbahnen höher ist als das Schmelzintegral einer Sicherung der Überstromschutzeinrichtung (4) zum Schutz vor Kurzschlussströmen.

15. Elektronisches Installationsgerät nach Anspruch 8, **dadurch gekennzeichnet, dass** das gemeinsame Schmelzintegral der beiden Leiterbahnen (13, 14) des Widerstandselementes (9) höher ist als das Schmelzintegral der Überstromschutzeinrichtung (4) zum Schutz vor Kurzschlussströmen, und dass das Verhältnis der Schmelzintegrale der Leiterbahnen (13, 14) zueinander vorzugsweise in einem Verhältnis größer als 25 liegt.

16. Elektronisches Installationsgerät nach einem der Ansprüche 1 bis 15, **dadurch gekennzeichnet, dass** auf den beiden äußeren Hauptoberflächen (23, 24) der Leiterplattenanordnung (12) einerseits die Überstromschutzeinrichtung (4) zum Schutz vor Kurzschlussströmen und andererseits zumindest ein Sensorelement (11) der Überstromschutzeinrichtung (5) zum Schutz vor Überlastströmen angeordnet ist.

17. Elektronisches Installationsgerät nach einem der Ansprüche 1 bis 16, **dadurch gekennzeichnet, dass** die Leiterplattenanordnung (12) mehrere Schichten umfasst (19, 20, 21, 22, 25, 26, 27), auf denen jeweils ein- oder beidseitig elektrische Bauteile und/oder Leiterbahnen angeordnet sind.

18. Elektronisches Installationsgerät nach Anspruch 17, **dadurch gekennzeichnet, dass** die Schichten (19, 20, 21, 22, 25, 26, 27) zumindest teilweise flexibel und/oder unflexibel sind.

19. Elektronisches Installationsgerät nach einem der Ansprüche 1 bis 18, **dadurch gekennzeichnet, dass** ein Überlaststrom in einer schmalen Leiterbahn (13) eines Widerstandselementes (9) eine Erwärmung erzeugt, die aufgrund der thermischen Kopplung mit einem Sensorelement (11) eine Reaktion einer Steuereinrichtung (8) und damit eine temporäre Unterbrechung des Laststromkreises (2) hervorruft.

## Claims

1. An electronic installation device (1) for controlling a load in an electric circuit, said electronic installation device (1) having a single-layer or multilayer circuit board arrangement (12) having electrical components and conductor tracks and said electronic installation device (1) comprising a load circuit (2) and a control circuit (3) which are at least functionally coupled to one another, wherein the electronic installation device (1) has an overcurrent protection device (5) for protection against overload currents,
**characterized in that** the load circuit (2) has an overcurrent protection device (4) for protection against short-circuit currents, a resistor element (9) and a circuit interruption element (6) that can be arranged in series between a current source and an electrical load.

2. An electronic installation device in accordance with claim 1, **characterized in that** the control circuit (3) has the overcurrent protection device (5) for protection against overload currents that has an overcurrent detection device (10) and a control device (8) which is functionally connected to the circuit interruption element (6).

3. An electronic installation device in accordance with claim 1 or claim 2, **characterized in that** the circuit interruption element (6) is functionally connected to a relay (7) or to power semiconductor devices.

4. An electronic installation device in accordance with any one of the preceding claims, **characterized in that** the first overcurrent protection device (4) for protection against short-circuit currents is irreversible.

5. An electronic installation device in accordance with claim 2, **characterized in that** the overcurrent detection device (10) comprises a reversible sensor element (11) in the control circuit (3) and the resistor element (9) in the load circuit (2), with the sensor element (11) being thermally coupled to the resistor element (9).

6. An electronic installation device in accordance with claim 5, **characterized in that** the sensor element (11) is a positive temperature coefficient thermistor.

7. An electronic installation device in accordance with claim 5 or claim 6, **characterized in that** the resistor element (9) is arranged as a conductor track galvanically separated beneath the sensor element (11).

8. An electronic installation device in accordance with any one of the preceding claims, **characterized in that** the resistor element (9) comprises two conductor tracks (13, 14) of different widths and/or thicknesses connected in parallel.

9. An electronic installation device in accordance with claim 8, **characterized in that** the width ratio between the two conductor tracks (13, 14) is 5 to 1 with the same thickness and with the same material.

10. An electronic installation device in accordance with claim 8 or claim 9, **characterized in that** a narrow conductor track (13) comprises a section narrowed in the width or a section thinned in the height.

11. An electronic installation device in accordance with any one of the claims 8 to 10, **characterized in that** a wide conductor track (14) absorbs a short-circuit current, while a narrow conductor track (13) serves to detect the overload current.

12. An electronic installation device in accordance with any one of the claims 8 to 11, **characterized in that** the two conductor tracks (13, 14) of the resistor element (9) are arranged in different layers (19, 20, 21, 22) of the circuit board arrangement (12).

13. An electronic installation device in accordance with claim 5 and any one of the claims 8 to 12, **characterized in that** a narrow conductor track (13) is arranged close to the surface or on the surface (24) of an outer layer (22), with the sensor element (11) being arranged in a thermally contacted and electrically insulated manner with respect to the conductor track (13).

14. An electronic installation device in accordance with any one of the claims 1 to 13, **characterized in that** the melting integral of protected components and conductor tracks is higher than the melting integral of a fuse of the overcurrent protection device (4) for protection against short-circuit currents.

15. An electronic installation device in accordance with claim 8, **characterized in that** the common melting integral of the two conductor tracks (13, 14) of the resistor element (9) is higher than the melting integral of the overcurrent protection device (4) for protection against short-circuit currents, and **in that** the ratio of the melting integrals of the conductor tracks (13, 14) to one another is preferably in a ratio greater than 25.

16. An electronic installation device in accordance with any one of the claims 1 to 15, **characterized in that** the overcurrent protection device (4) for protection against short-circuit currents, on the one hand, and at least one sensor element (11) of the overcurrent protection device (5) for protection against overload currents, on the other hand, are arranged on the two outer main surfaces (23, 24) of the circuit board arrangement (12).

17. An electronic installation device in accordance with any one of the claims 1 to 16, **characterized in that** the circuit board arrangement (12) comprises a plurality of layers (19, 20, 21, 22, 25, 26, 27) on each of which electrical components and/or conductor tracks are arranged at one or both sides.

18. An electronic installation device in accordance with claim 17, **characterized in that** the layers (19, 20, 21, 22, 25, 26, 27) is/are at least partly flexible and/or inflexible.

19. An electronic installation device in accordance with any one of the claims 1 to 18, **characterized in that** an overload current generates a heating in a narrow conductor track (13) of a resistor element (9), which heating causes a reaction of a control device (8), and thus a temporary interruption of the load circuit (2), due to the thermal coupling with a sensor element (11).

## Revendications

1. Appareil d'installation électronique (1) destiné à commander une charge dans un circuit électrique, comprenant un ensemble de carte de circuit imprimé (12) à une ou plusieurs couches avec des composants électriques et des pistes conductrices, et comprenant un circuit de charge (2) et un circuit de commande (3) qui sont couplés au moins fonctionnellement l'un à l'autre, l'appareil d'installation électronique (1) comprenant un dispositif de protection contre les surintensités (5) pour la protection contre les courants de surcharge,
**caractérisé en ce que** le circuit de charge (2) comprend un dispositif de protection contre les surintensités (4) pour la protection contre les courants de court-circuit, un élément résistif (9) et un élément de coupure de circuit (6), qui peuvent être disposés en série entre une source de courant et une charge électrique.

2. Appareil d'installation électronique selon la revendication 1,
**caractérisé en ce que** le circuit de commande (3) comprend le dispositif de protection contre les surintensités (5) pour la protection contre les courants de surcharge, qui comprend un dispositif de détection de surintensités (10) et un dispositif de commande (8), qui est connecté fonctionnellement à l'élément de coupure de circuit (6).

3. Appareil d'installation électronique selon la revendication 1 ou 2, **caractérisé en ce que** l'élément de coupure de circuit (6) est connecté fonctionnellement à un relais (7) ou à des composants semi-conducteurs de puissance.

4. Appareil d'installation électronique selon l'une des revendications précédentes,
**caractérisé en ce que** le dispositif de protection contre les surintensités (4) pour la protection contre les courants de court-circuit est irréversible.

5. Appareil d'installation électronique selon la revendication 2,
**caractérisé en ce que** le dispositif de détection de surintensités (10) est constitué d'un élément capteur réversible (11) dans le circuit de commande (3) et de l'élément résistif (9) dans le circuit de charge (2), l'élément capteur (11) étant couplé thermiquement à l'élément résistif (9).

6. Appareil d'installation électronique selon la revendication 5,
**caractérisé en ce que** l'élément capteur (11) est une thermistance à coefficient de température positif.

7. Appareil d'installation électronique selon la revendication 5 ou 6, **caractérisé en ce que** l'élément résistif (9) est disposé sous forme de piste conductrice séparée galvaniquement en dessous de l'élément capteur (11).

8. Appareil d'installation électronique selon l'une des revendications précédentes,
**caractérisé en ce que** l'élément résistif (9) est constitué de deux pistes conductrices (13, 14) de largeur et/ou d'épaisseur différente, montées en parallèle.

9. Appareil d'installation électronique selon la revendication 8,
**caractérisé en ce que** le rapport de largeur entre les deux pistes conductrices (13, 14) est de préférence de 5 sur 1 pour une même épaisseur et pour un même matériau.

10. Appareil d'installation électronique selon la revendication 8 ou 9,
**caractérisé en ce qu'**une piste conductrice étroite (13) comprend une section rétrécie en largeur ou une section amincie en hauteur.

11. Appareil d'installation électronique selon l'une des revendications 8 à 10,
**caractérisé en ce qu'**une piste conductrice large (14) absorbe un courant de court-circuit, tandis qu'une piste conductrice étroite (13) sert à détecter le courant de surcharge.

12. Appareil d'installation électronique selon l'une des revendications 8 à 11,
**caractérisé en ce que** les deux pistes conductrices (13, 14) de l'élément résistif (9) sont disposées dans des couches différentes (19, 20, 21, 22) de l'ensemble de carte de circuit imprimé (12).

13. Appareil d'installation électronique selon la revendication 5 et l'une des revendications 8 à 12,
**caractérisé en ce qu'**une piste conductrice étroite (13) est disposée à proximité de la surface ou sur la surface (24) d'une couche extérieure (22), l'élément capteur (11) étant disposé thermiquement en contact et électriquement isolée par rapport à la piste conductrice (13).

14. Appareil d'installation électronique selon l'une des revendications 1 à 13,
**caractérisé en ce que** l'intégrale de fusion des composants et des pistes conductrices protégés est supérieure à l'intégrale de fusion d'un fusible du dispositif de protection contre les surintensités (4) pour la protection contre les courants de court-circuit.

15. Appareil d'installation électronique selon la revendication 8,
**caractérisé en ce que** l'intégrale de fusion commune des deux pistes conductrices (13, 14) de l'élément résistif (9) est supérieure à l'intégrale de fusion du dispositif de protection contre les surintensités (4) pour la protection contre les courants de court-circuit, et
**en ce que** le rapport des intégrales de fusion des pistes conductrices (13, 14) entre elles est de préférence dans un rapport supérieur à 25.

16. Appareil d'installation électronique selon l'une des revendications 1 à 15,
**caractérisé en ce que** sur les deux surfaces principales extérieures (23, 24) de l'ensemble de carte de circuit imprimé (12) sont disposés d'une part le dispositif de protection contre les surintensités (4) pour la protection contre les courants de court-circuit, et d'autre part au moins un élément capteur (11) du dispositif de protection contre les surintensités (5) pour la protection contre les courants de surcharge.

17. Appareil d'installation électronique selon l'une des revendications 1 à 16,
**caractérisé en ce que** l'ensemble de carte de circuit imprimé (12) comprend une ou plusieurs couches (19, 20, 21, 22, 25, 26, 27) sur chacune desquelles sont disposés, d'un côté ou des deux côtés, des composants électriques et/ou des pistes conductrices.

18. Appareil d'installation électronique selon la revendication 17,
**caractérisé en ce que** les couches (19, 20, 21, 22, 25, 26, 27) sont au moins partiellement flexibles et/ou non flexibles.

19. Appareil d'installation électronique selon l'une des revendications 1 à 18,
**caractérisé en ce qu'**un courant de surcharge engendre, dans une piste conductrice étroite (13) d'un élément résistif (9), un échauffement qui, en raison du couplage thermique avec un élément capteur (11), provoque une réaction d'un dispositif de commande (8) et ainsi une coupure temporaire du circuit de charge (2).
